# EUROPÄISCHE PATENTANMELDUNG

(11) **EP 2 592 173 A2**
(43) Veröffentlichungstag der Anmeldung: **15.05.2013**
(21) Anmeldenummer: 12191796.7
(22) Anmeldetag: 08.11.2012
(51) Int. Cl.: C23C 16/46, C23C 16/54, C23C 16/455

(54) **Anordnung und Verfahren zur Durchführung eines Niedertemperatur - ALD-Prozesses**

(30) Priorität: 08.11.2011 DE 102011085914
(71) Anmelder: FHR Anlagenbau GmbH, 01458 Ottendorf-Okrilla (DE)
(72) Erfinder: Häberlein, Sven, 01458 Ottendorf-Okrilla (DE); Gawer, Olaf, 01328 Dresden (DE)
(74) Vertreter: Lippert, Stachow & Partner

(57) **Zusammenfassung**

Die Erfindung betrifft eine Anordnung und ein Verfahren zur Durchführung eines Niedertemperatur-ALD-Prozesses zum Herstellen von Materialfilmen auf flächigen Substraten in einer evakuierbaren Vakuumbeschichtungskammer, die mit einem Einlass für ein Precursor-Gas und einer Heizung zur Erwärmung des Substrates versehen ist. Durch die Erfindung soll eine Anordnung und ein Verfahren zur Durchführung eines Niedertemperatur-ALD-Prozess zum Herstellen von Materialfilmen auf flächigen Temperatur sensiblen Substraten geschaffen werden, wobei sichergestellt werden soll, dass die Temperatur der Substrate während des ALD-Prozesses nicht nennenswert ansteigt. Erreicht wird das dadurch, dass die Vakuumbeschichtungskammer (1) nach unten offen ausgeführt ist und nach oben durch eine vakuumdicht eingepasste Blitzlampenbox (2) mit einem Blitzlampenfeld (3) als Heizung abgedeckt ist und dass die Vakuumbeschichtungskammer (1) von unten mit einem Hubtisch (8) zur Aufnahme eines bandförmigen Substrates (7) vakuumdicht verschließbar ist. (Fig. 1)

## Beschreibung

Die Erfindung betrifft eine Anordnung und ein Verfahren zur Durchführung eines Niedertemperatur-ALD-Prozesses zum Herstellen von Materialfilmen auf flächigen Substraten in einer evakuierbaren Vakuumbeschichtungskammer, die mit einem Einlass für ein Precursor-Gas und einer Heizung zur Erwärmung des Substrates versehen ist.

Solche Substrate können Kunststofffolien, Metallfolien usw. sein, die auf einer Seite mittels eines oder mehrerer aufeinander folgender ALD-Prozesse (ALD: Atomic Layer Deposition) mit einer oder mehreren Atomschichten von Materialien beschichtet werden. Ein ALD-Prozess ist dadurch gekennzeichnet, dass zunächst verschiedene Precursor-Gase in die Vakuumbeschichtungskammer eingeleitet und auf dem Substrat abgeschieden werden. Unter Precursoren sind Vorläufersubstanzen zu verstehen. Die gewünschten Materialfilme auf dem Substrat werden anschließend durch einen chemischen Prozess erzeugt, der thermisch und/oder plasmachemisch unterstützt/ausgelöst wird.

Die zusätzliche Wärmebeaufschlagung infolge des ALD-Prozesses ist aus prozesstechnischen Gründen notwendig und wird im Allgemeinen über im Vakuum oder in einer separaten Kammer installierte Strahlungs- bzw. Kontaktheizungen realisiert. Es ist auch bekannt, eine nachträgliche thermische Behandlung des aufgebrachten Materialfilmes mittels Blitzlampen durchzuführen.

Die Heizung ist in der Regel so dimensioniert, dass die Temperatur des zu beschichtenden Substrates über den gesamten Prozessablauf stabilisiert wird.

Für temperatursensible Substrate, wie Kunststoffe und insbesondere Kunststofffolien, ist auf Grund der notwendigen Prozesstemperaturen eine Beschichtung mittels eines ALD-Prozesses nicht, oder nur eingeschränkt möglich.

Bei den temperatursensiblen Substraten muss sichergestellt werden, dass deren Temperatur während des ALD-Prozesses nicht nennenswert ansteigt, d.h. im Niedertemperaturbereich um Raumtemperatur bleibt. Das steht allerdings im Widerspruch zu den Erfordernissen der ALD-Prozesse, die in der Regel Schichttemperaturen um bis zu mehrere hundert Grad erfordern.

Der Erfindung liegt nun die Aufgabe zugrunde, eine Anordnung und ein Verfahren zur Durchführung eines Niedertemperatur-ALD-Prozess zum Herstellen von Materialfilmen auf flächigen temperatursensiblen Substraten zu schaffen, wobei insbesondere sicherzustellen ist, dass deren Temperatur während des ALD-Prozesses nicht nennenswert ansteigt.

Die der Erfindung zugrundeliegende Aufgabe wird dadurch gelöst, dass die Vakuumbeschichtungskammer nach unten offen ausgeführt ist und nach oben durch eine vakuumdicht eingepasste Blitzlampenbox mit einem Blitzlampenfeld als Heizung abgedeckt ist und dass die Vakuumbeschichtungskammer von unten mit einem Hubtisch zur Aufnahme eines bandförmigen Substrates vakuumdicht verschließbar ist.

In einer ersten Ausgestaltung der Erfindung sind zwischen dem unteren Rand der Vakuumbeschichtungskammer und dem Hubtisch schlitzförmige Öffnungen als Durchlässe zum Hindurchführen des bandförmigen Substrates über den Hubtisch vorgesehen.

Für eine kontinuierliche oder schrittweise Beschichtung ist das bandförmige Substrat von einer Vorratsrolle zu einer Aufwickelrolle durch die Vakuumbeschichtungskammer geführt, wobei die Rollen außerhalb der Vakuumbeschichtungskammer angeordnet sind.

In einer Ausgestaltung der Erfindung sind die schlitzförmigen Öffnungen zugleich als Einlässe für das Precursor-Gas ausgebildet.

Um beim Absenken des Hubtisches eine Belüftung der Vakuumbeschichtungskammer zu vermeiden, ist diese einschließlich der Rolle-zu-Rolle Anordnung für das bandförmige Substrat durch eine weitere Vakuumkammer vollständig umhüllt.

Die der Erfindung zugrunde liegende Aufgabe wird weiterhin dadurch gelöst, dass die Vakuumbeschichtungskammer nach oben durch eine vakuumdicht eingepasste Blitzlampenbox mit einem Blitzlampenfeld als Heizung abgedeckt ist und dass die Vakuumbeschichtungskammer im unteren Teil mit einer Aufnahme für Einzel-Substrate vakuumdicht verschlossen ist.

Die Aufnahme für die Einzel-Substrate kann als eine Platte ausgebildet sein oder aus einzelnen Stützen, Pins etc. bestehen.

Zum Schutz von unerwünschten Ablagerungen im Bereich der Blitzlampenbox ist bei beiden erfindungsgemäßen Vakuumbeschichtungskammern zwischen der Blitzlampenbox und dem Substrat ein Schutzfenster angeordnet.

Die der Erfindung zugrunde liegende Aufgabe wird schließlich durch Verfahren zur Durchführung eines Niedertemperatur-ALD-Prozesses zum Herstellen von Materialfilmen auf flächigen Substraten in einer evakuierbaren Vakuumbeschichtungskammer, gelöst, das gekennzeichnet ist durch
- teilweises oder vollständiges Einbringen eines Substrates in die Vakuumbeschichtungskammer,
- Einlassen eines ersten Precursorgases in die Vakuumbeschichtungskammer,
- Durchführen eines ersten Spülvorganges in der Vakuumbeschichtungskammer,
- Einlassen eines zweiten Precursorgases,
- Anblitzen des Substrates mit kürzest möglicher Einschaltzeit,
- Durchführen eines weiteren Spülvorganges in der Vakuumbeschichtungskammer, und
- Wiederholung der Verfahrensschritte bis die gewünschte Schichtdicke des Materialfilmes auf dem Substrat erreicht ist.

Das Substrat kann auch jeweils mehrfach angeblitzt werden.

Es ist auch möglich, dass das Anblitzen des Substrates während oder nach jedem Verfahrensschritt vorgenommen wird.

Es versteht sich, dass das Anblitzen des Substrates in Richtung zur Beschichtung erfolgt.

Alternativ ist vorgesehen, dass das Substrat während des Einlassens des zweiten Precursorgases in die Vakuumbeschichtungskammer, oder während des zweiten Spülvorganges angeblitzt wird.

Die Erfindung wird nachfolgend an Ausführungsbeispielen näher beschrieben. In den zugehörigen Zeichnungsfiguren zeigen:
Fig. 1: eine schematische Darstellung einer Niedertemperatur-ALD-Vorrichtung mit Blitzunterstützung für Niedertemperatur-ALD-Beschichtungen für bandförmige Substrate im Durchlaufverfahren; und
Fig. 2: eine schematische Darstellung einer Niedertemperatur-ALD-Vorrichtung mit Blitzunterstützung für Niedertemperatur-ALD-Beschichtungen für dünne Einzel-Substrate.

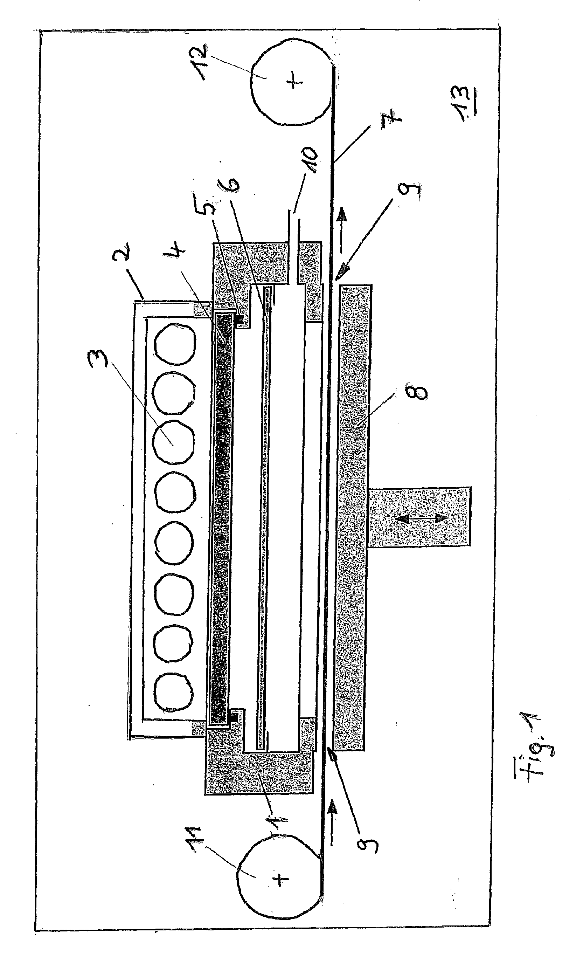

Nach Fig. 1 besteht die Niedertemperatur-ALD-Vorrichtung aus einer zeichnungsgemäß nach unten offenen Vakuumbeschichtungskammer 1 (Prozesskammer), die oben durch eine vakuumdicht eingepasste Blitzlampenbox 2 mit einem Blitzlampenfeld 3 und einem Fenster 4 abgedeckt wird. Das Fenster 4 in der Blitzlampenbox 2 ist mittels Dichtungen 5 vakuumdicht in die Vakuumkammer 1 eingesetzt. Das Blitzlampenfeld 3 ersetzt die sonst bei ALD-Prozessen erforderliche Heizung. Unterhalb der Blitzlampenbox 2 befindet sich in der Vakuumbeschichtungskammer 1 ein optionales Schutzfenster 6 zum Schutz von unerwünschten Ablagerungen im Bereich der Blitzlampenbox 2.

Unter der Vakuumbeschichtungskammer 1 wird ein bandförmiges Substrat 7 über einen vertikal verfahrbaren Hubtisch 8 geführt, der gleichzeitig dazu dient, die Vakuumbeschichtungskammer 1 während des ALD-Prozesses zu verschließen, wobei schlitzförmige Öffnungen 9 für das bandförmige Substrat 7 freigehalten sind.

Als bandförmige Substrate 7 kommen beispielsweise Kunststoff- oder Metallfolien oder andere dünne Folien in Betracht.

Weiterhin ist die Vakuumbeschichtungskammer 1 mit mindestens einem Einlass/Auslass 10 für Precursorgase, sowie mit einem nicht dargestellten Anschluss für eine Vakuumpumpe versehen.

Nachdem die nötigen Verfahrensschritte in der Vakuumbeschichtungskammer 1 zur Herstellung eines Materialfilmes auf dem Substrat abgearbeitet sind, wird der Hubtisch 8 etwas abgesenkt, um das bandförmige Substrat 7 freizugeben, so dass dieses dann durch die schlitzförmige Öffnungen 8 weiter transportiert werden kann. Das kann von einer Vorratsrolle 11 zu einer Aufwickelrolle 12, die sich außerhalb der Vakuumbeschichtungskammer 1 befinden, erfolgen.

Da das Absenken des Hubtisches 8 zu einer unerwünschten Belüftung der Vakuumbeschichtungskamer 1 führen würde, wird die in Fig. 1 dargestellte ALD-Vorrichtung einschließlich der Rolle-zu-Rolle Anordnung 11, 12 für das bandförmige Substrat 7 durch eine weitere Vakuumkammer 13 vollständig umhüllt.

Alternativ kann das bandförmige Substrat 7 kontinuierlich oder schrittweise durch die schlitzförmigen Öffnungen 9 bewegt werden (ohne Hubtischfunktion), da nur in der wärmebestrahlten Fläche eine Reaktion der aufgetragenen Precursoren stattfindet. In diesem Fall werden die Precursorgase ebenso oder ausschließlich durch eine der schlitzförmigen Öffnungen 9 gepumpt.

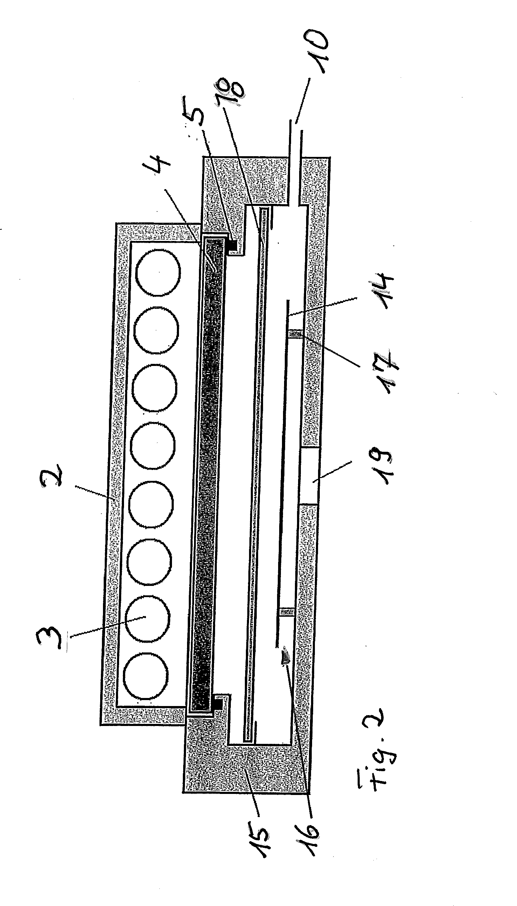

Die in Fig. 2 dargestellte ALD-Vorrichtung mit Blitzunterstützung ist für die Niedertemperatur-ALD-Beschichtung dünner Einzel-Substrate 14 vorgesehen. Im zeichnungsgemäß oberen Bereich der Vakuumbeschichtungskammer 15 befindet sich ebenfalls eine Blitzlampenbox 2 mit einem Blitzlampenfeld 3, welche die sonst bei ALD-Prozessen erforderliche Heizung ersetzt. Unterhalb der Blitzlampenbox 2 befindet sich Fenster 4, welches über Dichtungen 5 vakuumdicht in die Vakuumbeschichtungskammer 15 eingesetzt ist. Die Einzel-Substrate 14 sind hier in der Vakuumbeschichtungskammer 15 auf einer Aufnahme 16 in Form einer Platte oder von einzelnen Stützen 17, Pins etc. angeordnet.

Der untere Teil (Bodenteil) der Vakuumbeschichtungskammer 15 kann lösbar mit dieser verbunden sein und beispielsweise als Teil eines Hubtisches 8 wie in Fig. 1 ausgebildet sein. Die Zuführung der Precursorgase erfolgt hier über einen Einlass /Auslass 10.

Die ALD-Vorrichtung nach Fig. 2 ist für dünne Einzel-Substrate 14 aus Kunststoff, Metall oder anderen Materialien besonders geeignet. Sollen die Einzelsubstrate 14 auf Stützen 17 oder Pins in der Vakuumbeschichtungskammer 15 gelagert werden, so müssen diese eine genügende Eigensteifigkeit besitzen, andernfalls müssen die Einzel-Substrate 14 durch eine Platte oder andere Unterstützungsmittel unterstützt werden.

Weiterhin befindet sich bei beiden Ausführungen nach Fig. 1, 2 zwischen der Blitzlampenbox 2 und dem Substrat 7, 14 ein Schutzfenster 18 zum Schutz des Bereiches der Blitzlampenbox 2 vor unerwünschten Ablagerungen.

Bei der Ausführung nach Fig. 2 kann ein Anschluss 19 für eine Vakuumpumpe im unteren Bereich der Vakuumbeschichtungskammer 15 unterhalb des Einzel-Substrates 14 oder an einer anderen geeigneten Stelle angeordnet werden.

Erfindungsgemäß wird bei einem ALD-Prozess der eingangs genannten Art die Substratheizung durch eine hochenergetische impulsartige Wärmebeaufschlagung in der Vakuumkammer abgelöst, die durch extrem kurze Einschaltzeiten des Blitzlampenfeldes 3 gekennzeichnet ist. Das kann mit dem Blitzlampenfeld 3 mit regelbarer Blitzenergie, beispielsweise mit einem FLA-Prozess erfolgen (FLA: Flash Lamp Annealing).

Damit wird lediglich eine lokale Erwärmung des Substrates 7, 14 im Bereich des aufzubringenden Materialfilmes bzw. in diesem Materialfilm auf die notwendige Prozesstemperatur ohne tiefgreifende Erwärmung des Substrates 7, 14 selber erreicht.

Die in die Schicht lokal einzubringende Energie muss derart bemessen werden, dass die infolge von Wärmeleitung im Substrat 7, 14 eintretende Verteilung der Wärme nur zu einer geringfügigen Erwärmung desselben führt, die im Bereich von Raumtemperatur liegen sollte. Folglich muss mit kürzest möglichen Einschaltzeiten des Blitzlampenfeldes gearbeitet werden, wobei gleichzeitig die Blitzenergie entsprechend gesteuert werden kann, um eine kurzzeitige Erwärmung des auf das Substrat 7, 14 aufgebrachten Materialfilmes auf die erforderliche Reaktionstemperatur der Precursoren zu erreichen.

Unter Raumtemperatur soll eine Temperatur verstanden werden, die um 20 °C liegt.

Der Verfahrensablauf gestaltet sich wie folgt:
- teilweises oder vollständiges Einbringen eines Substrates 7, 14 in die Vakuumbeschichtungskammer 1, 15 und Herstellen eines Vakuums in dieser,
- Einlassen eines ersten Precursorgases in die Vakuumbeschichtungskammer 1, 15,
- Durchführen eines ersten Spülvorganges in der Vakuumbeschichtungskammer 1, 15,
- Einlassen eines zweiten Precursorgases in die Vakuumbeschichtungskammer 1, 15,
- Anblitzen des Substrates 7, 14 mit kürzest möglicher Einschaltzeit des Blitzlampenfeldes 3
- Durchführen eines zweiten Spülvorganges in der Vakuumbeschichtungskammer 1, 15,
- Wiederholung der Verfahrensschritte bis die gewünschte Schichtdicke des Materialfilmes erreicht ist.

Das Substrat 7, 14 kann mit kürzest möglicher Einschaltzeit des Blitzlampenfeldes 3 auch mehrfach angeblitzt werden, wobei das Anblitzen der Substrate 7, 14 während oder nach jedem Verfahrensschritt erfolgen kann.

Alternativ ist es auch möglich, das Substrat 7, 14 während des Einlassens des zweiten Precursorgases in die Vakuumbeschichtungskammer 1, 15 anzublitzen, oder während des zweiten Spülvorganges.

Nachdem die Herstellung des gewünschten Materialfilmes auf dem bandförmigen Substrat 7 abgeschlossen ist, kann das bandförmige Substrat 7 ggf. nach geringfügigem Absenken des Hubtisches 8 weiter transportiert werden. Ein vorheriges Belüften der Vakuumbeschichtungskammer 1 kann entfallen, wenn diese und das Rolle-zu-Rolle System 11, 12 durch eine Vakuumkammer 13 umhüllt ist. Das hat den besonderen Vorteil, dass die Vakuumbeschichtungskammer 1 und die Vakuumkammer 13 erst dann belüftet werden müssen, wenn das bandförmige Substrat 7 vollständig beschichtet ist. Auf diese Weise wird Energie eingespart, wodurch eine kostengünstigere Beschichtung von bandförmigen Substraten ermöglicht wird.

Handelt es sich um Einzel-Substrate 14, so muss die Vakuumbeschichtungskammer 15 zunächst belüftet werden, woraufhin dann das beschichtete Einzel-Substrat 14 nach dem Öffnen der Vakuumbeschichtungskammer 15 entnommen werden kann. Alternativ könnte auch die Ausführung nach Fig. 2 auch durch eine Vakuumkammer 11 umhüllt werden und in dieser ein Magazinsystem zur Bevorratung der Einzel-Substrate 14, zum Transport in die und aus der Vakuumbeschichtungskammer 15, sowie zur Speicherung von beschichteten Einzel-Substraten 14 angeordnet werden.

### Bezugszeichenliste

- 1: Vakuumbeschichtungskammer
- 2: Blitzlampenbox
- 3: Blitzlampenfeld
- 4: Fenster
- 5: Dichtung
- 6: Schutzfenster
- 7: bandförmiges Substrat
- 8: Hubtisch
- 9: schlitzförmige Öffnung
- 10: Einlass/Auslass
- 11: Vorratsrolle
- 12: Aufwickelrolle
- 13: Vakuumkammer
- 14: Einzel-Substrat
- 15: Vakuumbeschichtungskammer
- 16: Aufnahme
- 17: Stütze
- 18: Schutzfenster
- 19: Anschluss

## Patentansprüche

1. Anordnung zur Durchführung eines Niedertemperatur-ALD-Prozess zum Herstellen von Materialfilmen auf flächigen Substraten in einer evakuierbaren Vakuumbeschichtungskammer, die mit einem Einlass für ein Precursor-Gas und einer Heizung zur Erwärmung des Substrates versehen ist, **dadurch gekennzeichnet, dass** die Vakuumbeschichtungskammer (1) nach unten offen ausgeführt ist und nach oben durch eine vakuumdicht eingepasste Blitzlampenbox (2) mit einem Blitzlampenfeld (3) als Heizung abgedeckt ist und dass die Vakuumbeschichtungskammer (1) von unten mit einem Hubtisch (8) zur Aufnahme eines bandförmigen Substrates (7) vakuumdicht verschließbar ist.

2. Anordnung nach Anspruch 1, **dadurch gekennzeichnet, dass** zwischen dem unteren Rand der Vakuumbeschichtungskammer (1) und dem Hubtisch (8) schlitzförmige Öffnungen (9) als Durchlässe zum Hindurchführen des bandförmigen Substrates (7) über den Hubtisch (8) vorgesehen sind.

3. Anordnung nach Anspruch 1 und 2, **dadurch gekennzeichnet, dass** das bandförmige Substrat (7) von einer Vorratsrolle (11) zu einer Aufwickelrolle (12) durch die Vakuumbeschichtungskammer (1) geführt ist, wobei die Rollen (11, 12) außerhalb der Vakuumbeschichtungskammer (1) angeordnet sind.

4. Vorrichtung nach Anspruch 1 und 2, **dadurch gekennzeichnet, dass** die schlitzförmigen Öffnungen (9) zugleich als Ein- Auslässe für das Precursorgas ausgebildet sind.

5. Vorrichtung nach den Ansprüchen 1 bis 4, **dadurch gekennzeichnet, dass** die Vakuumbeschichtungskammer (1) einschließlich der Rolle-zu-Rolle Anordnung (11, 12) für das bandförmige Substrat (7) durch eine weitere Vakuumkammer (13) vollständig umhüllt ist.

6. Anordnung zur Durchführung eines Niedertemperatur-ALD-Prozess zum Herstellen von Materialfilmen auf flächigen Einzelsubstraten in einer evakuierbaren Vakuumbeschichtungskammer, die mit einem Einlass für ein Precursor-Gas und einer Heizung zur Erwärmung des Einzelsubstrates versehen ist, **dadurch gekennzeichnet, dass** die Vakuumbeschichtungskammer (15) nach oben durch eine vakuumdicht eingepasste Blitzlampenbox (2) mit einem Blitzlampenfeld (3) als Heizung abgedeckt ist und dass die Vakuumbeschichtungskammer (15) im unteren Teil mit einer Aufnahme (16) für Einzel-Substrate (14) vakuumdicht verschlossen ist.

7. Vorrichtung nach Anspruch 6, **dadurch gekennzeichnet, dass** die Aufnahme (16) als eine Platte ausgebildet ist, oder aus einzelnen Stützen (17), Pins etc. besteht.

8. Anordnung nach einem der Ansprüche 1 bis 7, **dadurch gekennzeichnet, dass** zwischen der Blitzlampenbox (2) und dem Substrat (7, 14) ein Schutzfenster (18) angeordnet ist.

9. Verfahren zur Durchführung eines Niedertemperatur-ALD-Prozesses zum Herstellen von Materialfilmen auf flächigen Substraten in einer evakuierbaren Vakuumbeschichtungskammer, **gekennzeichnet durch**
teilweises oder vollständiges Einbringen eines Substrates (7, 14) in die Vakuumbeschichtungskammer (1, 15) und Herstellen eines Vakuums in dieser,
Einlassen eines ersten Precursorgases in die Vakuumbeschichtungskammer (1, 15),
Durchführen eines ersten Spülvorganges in der Vakuumbeschichtungskammer (1, 15),
Einlassen eines zweiten Precursorgases,
Anblitzen des Substrates (7, 14) mit kürzest möglicher Einschaltzeit,
Durchführen eines weiteren Spülvorganges in der Vakuumbeschichtungskammer (1, 15), und
Wiederholung der Verfahrensschritte bis die gewünschte Schichtdicke des Materialfilmes auf dem Substrat (7, 14) erreicht ist.

10. Verfahren nach Anspruch 9, **dadurch gekennzeichnet, dass** das Substrat (7, 14) jeweils mehrfach angeblitzt wird.

11. Verfahren nach Anspruch 9 oder 10, **dadurch gekennzeichnet, dass** das Anblitzen des Substrates (7, 14) während oder nach jedem Verfahrensschritt vorgenommen wird.

12. Verfahren nach Anspruch 9 oder 10, **dadurch gekennzeichnet, dass** das Substrat (7, 14) während des Einlassens des zweiten Precursorgases in die Vakuumbeschichtungskammer (1, 15), oder während des zweiten Spülvorganges angeblitzt wird.
